# EUROPEAN PATENT SPECIFICATION

(11) **EP 1 914 796 B1**
(45) Date of publication and mention of the grant of the patent: **06.06.2012**
(21) Application number: 07023865.4
(22) Date of filing: 25.08.1999
(51) Int. Cl.: H01L 21/322

(54) **Method of forming non-oxygen precipitating Czochralski silicon wafers**
Verfahren zur Herstellung eines Czochralski-Siliziumwafers ohne Sauerstoffniederschlag
Procédé de fabrication de tranches de silicium de Czochralski ne formant pas de précipités d'oxygène

(30) Priority: 02.09.1998 US 98822; 23.08.1999 US 379383
(43) Date of publication of application: 23.04.2008
(62) Divisional of application: 99945173.5
(73) Proprietor: MEMC Electronic Materials, Inc., St. Peters, Missouri 63376 (US)
(72) Inventor: Falster, Robert J., 20123 Milano (IT)
(74) Representative: Maiwald Patentanwalts GmbH

(56) References cited:
- EP-A- 0 732 431
- WO-A-98/38675
- WO-A-98/45507
- JP-A- 5 155 700
- JP-A- 7 321 120
- US-A- 4 868 133
- JACOB M ET AL: "Influence of RTP on vacancy concentrations" SEMICONDUCTOR PROCESS AND DEVICE PERFORMANCE MODELLING. SYMPOSIUM, SEMICONDUCTOR PROCESS AND DEVICE PERFORMANCE MODELLING. SYMPOSIUM, BOSTON, MA, USA, 2-3 DEC. 1997, 2 December 1997 (1997-12-02), - 3 December 1997 (1997-12-03) pages 129-134, XP000856047 1998, Warrendale, PA, USA, Mater. Res. Soc, USA ISBN: 1-55899-395-9
- FALSTER R ET AL: "The engineering of silicon wafer material properties through vacancy concentration profile control and the achievement of ideal oxygen precipitation behavior" DEFECT AND IMPURITY ENGINEERED SEMICONDUCTORS II. SYMPOSIUM, DEFECT AND IMPURITY ENGINEERED SEMICONDUCTORS II. SYMPOSIUM, SAN FRANCISCO, CA, USA, 13-17 APRIL 1998, 13 April 1998 (1998-04-13), - 17 April 1998 (1998-04-17) pages 27-35, XP000856048 1998, Warrendale, PA, USA, Mater. Res. Soc, USA ISBN: 1-55899-416-5
- HAWKINS G A ET AL: "Effect on rapid thermal processing on oxygen precipitation in silicon" DEFECTS IN ELECTRONIC MATERIALS. SYMPOSIUM, BOSTON, MA, USA, 30 NOV.-3 DEC. 1987, 30 November 1987 (1987-11-30), - 3 December 1987 (1987-12-03) pages 197-200, XP000856847 1988, Pittsburgh, PA, USA, Mater. Res. Soc, USA ISBN: 0-931837-72-3
- HAWKINS G A ET AL: "The effect of rapid thermal annealing on the precipitation of oxygen in silicon" JOURNAL OF APPLIED PHYSICS, 1 MAY 1989, USA, vol. 65, no. 9, 1 May 1989 (1989-05-01), pages 3644-3654, XP000857112 ISSN: 0021-8979
- CHIOU H -D: "The effects of preheatings on axial oxygen precipitation uniformity in czochralski silicon crystals" JOURNAL OF THE ELECTROCHEMICAL SOCIETY, JUNE 1992, USA, vol. 139, no. 6, June 1992 (1992-06), pages 1680-1684, XP002123950 ISSN: 0013-4651
- FUJIWARA Y ET AL: "Behavior of oxygen precipitation on annealing in CZ-Si single crystals", MEMOIRS OF THE FACULTY OF ENGINEERING, MIYAZAKI UNIVERSITY MIYAZAKI UNIV JAPAN, no. 25, August 1996 (1996-08), pages 87-92, ISSN: 0540-4924
- FALSTER R ET AL: "Effect of high temperature pre-anneal on oxygen precipitates nucleation kinetics in Si", DIFFUSION AND DEFECT DATA PART B (SOLID STATE PHENOMENA) BALABAN PUBLISHERS; SCITEC PUBLICATIONS SWITZERLAND, vol. 57-58, 1997, pages 123-128, ISSN: 1012-0394

## Description

### BACKGROUND OF THE INVENTION

The present invention generally relates to the preparation of semiconductor material substrates, especially silicon wafers, which are used in the manufacture of electronic components. More particularly, the present invention relates to a process for the treatment of Czochralski single crystal silicon wafers to dissolve existing oxygen clusters and precipitates, while preventing their formation upon a subsequent oxygen precipitation heat treatment.

Single crystal silicon, which is the starting material for most processes for the fabrication of semiconductor electronic components, is commonly prepared with the so-called Czochralski process wherein a single seed crystal is immersed into molten silicon and then grown by slow extraction. As molten silicon is contained in a quartz crucible, it is contaminated with various impurities, among which is mainly oxygen. At the temperature of the silicon molten mass, oxygen comes into the crystal lattice until it reaches a concentration determined by the solubility of oxygen in silicon at the temperature of the molten mass and by the actual segregation coefficient of oxygen in solidified silicon. Such concentrations are greater than the solubility of oxygen in solid silicon at the temperatures typical for the processes for the fabrication of electronic devices. As the crystal grows from the molten mass and cools, therefore, the solubility of oxygen in it decreases rapidly, whereby in the resulting slices or wafers oxygen is present in supersaturated concentrations.

During the thermal treatment cycles typically employed in the fabrication of electronic devices, oxygen precipitate nucleation centers may form and ultimately grown into large oxygen clusters or precipitates. The presence of such precipitates in the active device region of the wafer can impair the operation of the device. Historically, to address this problem electronic device fabrication processes included a series of steps which were designed to produce silicon having a zone or region near the surface of the wafer which is free of oxygen precipitates (commonly referred to as a "denuded zone" or a "precipitate free zone"). Denuded zones can be formed, for example, in a high-low-high thermal sequence such as (a) oxygen out-diffusion heat treatment at a high temperature (>1100 °C) in an inert ambient for a period of at least about 4 hours, (b) oxygen precipitate nuclei formation at a low temperature (600-750 °C), and (c) growth of oxygen (SiO₂) precipitates at a high temperature (1000-1150 °C). See, e.g., F. Shimura, Semiconductor Silicon Crystal Technology, Academic Press, Inc., San Diego California (1989) at pages 361-367 and the references cited therein.

CHIOU H -D: "The effects of preheatings on axial oxygen precipitation uniformity in czochralski silicon crystals", JOURNAL OF THE ELECTROCHEMICAL SOCIETY, JUNE 1992, USA, vol. 139, no. 6, June 1992 (1992-06), pages 1680-1684, XP002123950, ISSN: 0013-4651 discloses that a very short high temperature rapid thermal annealing can reduce the thermal history effect.

FUJIWARA Y ET AL: "Behavior of oxygen precipitation on annealing in CZ-Si single crystals", MEMOIRS OF THE FACULTY OF ENGINEERING, MIYAZAKI UNIVERSITY MIYAZAKI UNIV JAPAN, no. 25, August 1996 (1996-08), pages 87-92,
ISSN: 0540-4924 discloses that it is possible to control the generation of oxygen precipitates in samples which are slowly called down to 900°C.

More recently, however, advanced electronic device manufacturing processes such as DRAM manufacturing processes have begun to minimize the use of high temperature process steps. Although some of these processes retain enough of the high temperature process steps to produce a denuded zone, the tolerances on the material are too tight to render it a commercially viable product. Other current, highly advanced electronic device manufacturing processes contain no out-diffusion steps at all. Because of the problems associated with oxygen precipitates in the active device region, therefore, these electronic device fabricators must use silicon wafers which are incapable of forming oxygen precipitates anywhere in the wafer under their process conditions.

Accordingly, a process is needed by which existing oxygen clusters or precipitates in the silicon wafer may be dissolved, prior to the device fabrication, in such a way that future formation of oxygen precipitates within the wafer is prevented.

### SUMMARY OF THE INVENTION

Among the objects of the invention, therefore, is the provision of a Czochralski single crystal silicon wafer, as well as the process for the preparation thereof, in which oxygen clusters and precipitates have been dissolved; and, the provision of such a wafer which will not form oxygen precipitates or clusters upon being subjected to an oxygen precipitation heat treatment.

The present invention is directed to a process for heat-treating a Czochralski single crystal silicon wafer to dissolve oxygen precipitates or clusters, and to prevent future precipitate formation resulting from a subsequent thermal processing step. The process comprises heat-treating the wafer in a rapid thermal annealer at a temperature of at least about 1150 °C to dissolve existing oxygen clusters or precipitates, and controlling the cooling rate of the heat-treated wafer down to a temperature of less than about 950 °C to produce a wafer which is incapable of forming oxygen precipitates upon being subjected to an oxygen precipitation heat treatment.

Other objects and features of this invention will be in part apparent and in part pointed out hereinafter.

### DETAILED DESCRIPTION OF THE PREFERRED EMBODIMENTS

The process of the present invention affords the means by which to obtain a single crystal silicon wafer having a reduced concentration of oxygen precipitates or clusters, as well as other defects to which these precipitates are related. Additionally, the present process yields a wafer which, during essentially any subsequent oxygen precipitation heat treatment (e.g., annealing the wafer at a temperature of 800 °C for four hours and then at a temperature of 1000 °C for sixteen hours), will not form oxygen precipitates. The process of the present invention therefore acts to annihilate or dissolve a variety of pre-existing defects such as large oxygen clusters and certain kinds of oxygen induced stacking fault ("OISF") nuclei throughout the wafer. The dissolved oxygen which remains in the wafer will not precipitate, even if the wafer is subjected to an oxygen precipitation heat treatment.

The starting material for the process of the present invention is a single crystal silicon wafer which has been sliced from a single crystal ingot grown in accordance with conventional Czochralski crystal growing methods. Such methods, as well as standard silicon slicing, lapping, etching, and polishing techniques are disclosed, for example, in F. Shimura, Semiconductor Silicon Crystal Technology, Academic Press, 1989, and Silicon Chemical Etching, (J. Grabmaier ed.) Springer-Verlag, New York, 1982 (incorporated herein by reference). The silicon wafer may be polished or, alternatively, it may be lapped and etched but not polished. In addition, the wafer may have vacancy or self-interstitial point defects as the predominant intrinsic point defect. For example, the wafer may be vacancy dominated from center to edge, self interstitial dominated from center to edge, or it may contain a central core of vacancy of dominated material surrounded by an axially symmetric ring of self-interstitial dominated material.

Czochralski-grown silicon typically has an oxygen concentration within the range of about 5 x 10¹⁷ to about 9 x 10¹⁷ atoms/cm³ (ASTM standard F-121-83). Because the oxygen precipitation behavior of the wafer is essentially erased by the present process (i.e., the wafer is essentially rendered non-oxygen precipitating, even if subjected to an oxygen precipitation heat treatment), the starting wafer may have an oxygen concentration falling anywhere within or even outside the range attainable by the Czochralski process. Depending upon the cooling rate of the single crystal silicon ingot from the temperature of the melting point of silicon (about 1410 °C) through the range of about 750 °C to about 350 °C, oxygen precipitate nucleation centers may form in the single crystal silicon ingot from which the wafer is sliced.

The presence or absence of these nucleation centers in the starting material is not critical to the present invention. Preferably, however, these centers are capable of being dissolved by the rapid thermal anneal heat-treatment of the present invention.

In accordance with the process of the present invention, a single crystal silicon wafer is first subjected a heat treatment step in which the wafer is heated to an elevated temperature. Preferably, this heat treatment step is carried out in a rapid thermal annealer in which the wafer is rapidly heated to a target temperature and annealed at that temperature for a relatively short period of time. In general, the wafer is subjected to a temperature in excess of 1150 °C, preferably at least 1175 °C, more preferably at least about 1200 °C, and most preferably between about 1200 °C and 1275 °C. The wafer will generally be maintained at this temperature for at least one second, typically for at least several seconds (e.g., at least 3), preferably for several tens of seconds (e.g., 20, 30, 40, or 50 seconds) and, depending upon the pre-existing defects, for a period which may range up to about 60 seconds (which is near the limit for commercially available rapid thermal annealers).

The rapid thermal anneal may be carried out in any of a number of commercially available rapid thermal annealing ("RTA") furnaces in which wafers are individually heated by banks of high power lamps. RTA furnaces are capable of rapidly heating a silicon wafer, e.g., they are capable of heating a wafer from room temperature to 1200 °C in a few seconds. One such commercially available RTA furnace is the model 610 furnace available from AG Associates (Mountain View,

### CA).

Heat-treating the wafer at a temperature in excess of 1150 °C will cause the dissolution of a variety of pre-existing oxygen clusters and OISF nuclei. In addition, it will increase the number density of crystal lattice vacancies in the wafer.

Information obtained to date suggests that certain oxygen-related defects, such as ring oxidation induced stacking faults (OISF), are high temperature nucleated oxygen agglomerates catalyzed by the presence of a high concentration of vacancies. Furthermore, in high vacancy regions, oxygen clustering is believed to occur rapidly at elevated temperatures, as opposed to regions of low vacancy concentration where behavior is more similar to regions in which oxygen precipitate nucleation centers are lacking. Because oxygen precipitation behavior is influenced by vacancy concentration, therefore, the number of density of vacancies in the heat-treated wafer is controlled in the process of the present invention to avoid oxygen precipitation in a subsequent oxygen precipitation heat treatment.

Intrinsic point defects (vacancies and silicon self-interstitials) are capable of diffusing through single crystal silicon with the rate of diffusion being temperature dependant. The concentration profile of intrinsic point defects, therefore, is a function of the diffusivity of the intrinsic point defects and the recombination rate as a function of temperature. For example, the intrinsic point defects are relatively mobile at temperatures in the vicinity of the temperature at which the wafer is annealed in the rapid thermal annealing step, whereas they are essentially immobile for any commercially practical time period at temperatures of as much as 700 °C. Experimental evidence obtained to-date suggests that the effective diffusion rate of vacancies slows considerably at temperatures less than about 700 °C and perhaps as great as 800 °C, 900 °C, or even 1,000 °C, the vacancies can be considered to be immobile for any commercially practical time period.

In the present invention, therefore, the concentration of vacancies in the heat-treated wafer is controlled, at least in part, by controlling the cooling rate of the wafer through the temperature range at which vacancies are relatively mobile. As the temperature of the wafer is decreased through this range of temperatures, the vacancies diffuse to the wafer surface and are annihilated, thus leading to a change in the vacancy concentration profile with the extent of change depending upon the length of time the wafer is maintained at a temperature within this range and the magnitude of the temperature; in general, greater temperatures and longer diffusion times lead to increased diffusion. In general, the average cooling rate from the annealing temperature to the temperature at which vacancies are practically immobile (e.g., about 950 °C) is preferably no more than 20 °C per second, more preferably no more than about 10 °C, and still more preferably no more than about 5 °C per second.

Once the wafer is cooled to a temperature outside the range of temperatures at which crystal lattice vacancies are relatively mobile in the single crystal silicon, the cooling rate does not appear to significantly influence the precipitating characteristics of the wafer and thus, does not appear to be narrowly critical.

Conveniently, the cooling step may be carried out in the same atmosphere in which the heating step is carried out. Suitable atmospheres include, for example, nitriding atmospheres (that is, atmospheres containing nitrogen gas (N₂) or a nitrogen-containing compound gas, such as ammonia, which is capable of nitriding an exposed silicon surface); oxidizing (oxygen-containing) atmospheres; non-oxidizing, non-nitriding atmospheres (such as argon, helium, neon, carbon dioxide), and combinations thereof.

While the rapid thermal treatments employed in this process may result in the out-diffusion of a small amount of oxygen from the surface of the front and back surfaces of the wafer, the resulting heat-treated wafer has a substantially uniform interstitial oxygen concentration as a function of distance from the silicon surface. For example, a heat-treated wafer will have a substantially uniform concentration of interstitial oxygen from the center of the wafer to regions of the wafer which are within about 15 microns of the silicon surface, more preferably from the center of the silicon to regions of the wafer which are within about 10 microns of the silicon surface, even more preferably from the center of the silicon to regions of the wafer which are within about 5 microns of the silicon surface, and most preferably from the center of the silicon to regions of the wafer which are within about 3 microns of the silicon surface. In this context, a substantially uniform oxygen concentration shall mean a variance in the oxygen concentration of no more than about 50%, preferably no more than about 20%, and most preferably no more than about 10%.

## Claims

1. A process for heat-treating a Czochralski single crystal silicon wafer that comprises pre-existing oxygen clusters, oxygen precipitates, and/or oxidation-induced stacking fault nuclei to dissolve said oxygen clusters, oxygen precipitates, and/or oxidation-induced stacking fault nuclei, the process comprising heat-treating the wafer in a rapid thermal annealer at a temperature of at least 1150°C and controlling the rate of cooling from the maximum temperature achieved during the heat-treatment through a temperature range in which vacancies are relatively mobile to reduce the number density of vacancies in the single crystal silicon to a value such that oxygen precipitates will not form in the heat-treated wafer upon subjecting the wafer to an oxygen precipitation heat-treatment, wherein the cooling rate between the maximum temperature achieved during the heat-treatment to a temperature of 900°C is less than 20°C/second.

2. The process of claim 1 wherein the wafer is heat-treated at a temperature between 1200°C to 1275°C.

3. The process of claim 1 or 2 wherein the cooling rate is less than 10°C/second.

4. The process of claim 1 or 2 wherein the cooling rate is less than 5°C/second.

5. The process of claim 1 or 2 wherein the wafer is cooled in a nitriding atmosphere.

6. The process of claim 1 or 2 wherein the wafer is cooled in an oxidizing atmosphere.

7. The process of claim 1 or 2 wherein the wafer is cooled in a non-nitriding, non-oxidizing atmosphere.

## Patentansprüche

1. Ein Verfahren zur Wärmebehandlung einer Czochralski-Einkristallsiliziumscheibe, die bereits bestehende Sauerstoffanhäufungen, Sauerstoffpräzipitate und/oder Oxidations-induzierte Stapelfehlerkeime umfasst, um die genannten Sauerstoffanhäufungen, Sauerstoffpräzipitate und/oder Oxidations-induzierten Stapelfehlerkeime aufzulösen, das Verfahren umfassend die Wärmebehandlung der Scheibe in einem Schnellheizgerät bei einer Temperatur von mindestens 1150°C und die Kontrolle der Kühlungsrate von der Maximaltemperatur, die während der Wärmebehandlung erreicht wird, durch einen Temperaturbereich, bei dem die Leerstellen relativ beweglich sind, um die Dichte der Leerstellen in dem Siliziumeinkristall auf einen Wert zu reduzieren, bei dem sich keine Sauerstoffpräzipitate in der wärmebehandelten Scheibe bei einer Sauerstoffpräzipitations-Wärmebehandlung der Scheibe bilden, wobei die Kühlungsrate zwischen der Maximaltemperatur, die während der Wärmebehandlung erreicht wird, auf eine Temperatur von 900°C weniger als 20°C/Sekunde beträgt.

2. Das Verfahren gemäß Anspruch 1, wobei die Scheibe bei einer Temperatur zwischen 1200°C bis 1275°C wärmebehandelt wird.

3. Das Verfahren gemäß Anspruch 1 oder 2, wobei die Kühlungsrate weniger als 10°C/Sekunde beträgt.

4. Das Verfahren gemäß Anspruch 1 oder 2, wobei die Kühlungsrate weniger als 5°C/Sekunde beträgt.

5. Das Verfahren gemäß Anspruch 1 oder 2, wobei die Scheibe in einer Nitrieratmosphäre gekühlt wird.

6. Das Verfahren gemäß Anspruch 1 oder 2, wobei die Scheibe in einer oxidierenden Atmosphäre gekühlt wird.

7. Das Verfahren gemäß Anspruch 1 oder 2, wobei die Scheibe in einer nicht nitrierenden und nicht oxidierenden Atmosphäre gekühlt wird.

## Revendications

1. Procédé de traitement thermique d'une tranche de silicium monocristallin de Czochralski qui comprend des agrégats d'oxygène, des précipités d'oxygène et/ou des noyaux de défauts d'empilement induits par l'oxydation pré-existants , pour dissoudre lesdits agrégats d'oxygène, précipités d'oxygène et/ou noyaux de défauts d'empilement induits par l'oxydation, le procédé comprenant le traitement thermique de la tranche dans un appareil de recuit thermique rapide à une température d'au moins 1150°C et le contrôle de la vitesse de refroidissement à partir de la température maximale obtenue pendant le traitement thermique via une fourchette de températures dans laquelle les vides sont relativement mobiles pour réduire la densité numérique des vides dans le silicium monocristallin à une valeur de telle sorte que des précipités d'oxygène ne se formeront pas dans la tranche traitée thermiquement lorsque la tranche sera soumise à un traitement thermique de précipitation d'oxygène, dans lequel la vitesse de refroidissement entre la température maximale obtenue pendant le traitement thermique et une température de 900°C est inférieure à 20°C/seconde.

2. Procédé selon la revendication 1, dans lequel la tranche est traitée thermiquement à une température entre 1200°C et 1275°C.

3. Procédé selon la revendication 1 ou 2, dans lequel la vitesse de refroidissement est inférieure à 10°C/seconde.

4. Procédé selon la revendication 1 ou 2, dans lequel la vitesse de refroidissement est inférieure à 5°C/seconde.

5. Procédé selon la revendication 1 ou 2, dans lequel la tranche est refroidie dans une atmosphère nitrurante.

6. Procédé selon la revendication 1 ou 2, dans lequel la tranche est refroidie dans une atmosphère oxydante.

7. Procédé selon la revendication 1 ou 2, dans lequel la tranche est refroidie dans une atmosphère non nitrurante, non oxydante.
